# EUROPÄISCHE PATENTSCHRIFT

(11) **EP 3 508 868 B1**
(45) Veröffentlichungstag und Bekanntmachung des Hinweises auf die Patenterteilung: **26.02.2020**
(21) Anmeldenummer: 19150093.3
(22) Anmeldetag: 02.01.2019
(51) Int. Cl.: G01R 33/3875

(54) **NMR-SHIMSYSTEM**
NMR SHIM SYSTEM
SYSTÈME CORRECTEUR DE CHAMP MAGNÉTIQUE RMN

(30) Priorität: 04.01.2018 DE 102018200098
(43) Veröffentlichungstag der Anmeldung: 10.07.2019
(73) Patentinhaber: Bruker Switzerland AG, 8117 Fällanden (CH)
(72) Erfinder: Mayer, Markus, 8625 Gossau (CH)
(74) Vertreter: Kohler Schmid Möbus Patentanwälte

(56) Entgegenhaltungen:
- CN-A- 104 865 544
- JP-A- S63 237 508
- JP-A- 2001 218 750

## Beschreibung

Die Erfindung betrifft ein Shimsystem, insbesondere ein Spulensystem, zur Beeinflussung und Homogenisierung des Magnetfeldes eines NMR-Systems mit einem Spulenkörper, einem Verlängerungsrohr und einer Anschlusseinheit sowie mit auf dem Spulenkörper aufgebrachten Teilspulen mit Anschlussleitungen zur Anschlusseinheit und ein Verfahren zur Herstellung eines solchen Shimsystems.

Ein solches Shimsystem ist beispielsweise aus CN 104865544 A von WUHAN ZHONGKE MR TECHNOLOGY CO LTD (=Referenz [1]) und aus US 3735306 A beziehungsweise DE 21 52 006 C2 von VARIAN ASSOCIATES, INC. (=Referenz [2]) bekannt.

Die US 6 711 430 B1 zeigt ein Spulensystem für eine Magnetresonanzanwendung, bei dem eine Spule an eine Leiterplatte angeschlossen ist. Jedoch ist nicht beschrieben, dass die Spule eine auf einen Spulenkörper gewickelte Spule und Teil eines Shimsystems ist.

### Hintergrund der Erfindung

Zur Analyse von Probenzusammensetzungen oder zur Strukturbestimmung von Stoffen in Proben werden NMR-Verfahren eingesetzt. Die NMR-Spektroskopie ist ein leistungsfähiges Verfahren der instrumentellen Analytik. Bei diesen NMR-Verfahren ist die Probe einem starken statischen Magnetfeld B₀ in einer z-Richtung ausgesetzt, und es werden dazu orthogonale hochfrequente elektromagnetische Impulse in x- oder y-Richtung in die Probe eingestrahlt. Dabei kommt es zu einer Wechselwirkung mit den Kernspins des Probenmaterials. Die zeitliche Entwicklung dieser Kernspins der Probe erzeugt wiederum hochfrequente elektromagnetische Felder, welche in der NMR-Apparatur detektiert werden. Aus den detektierten HF-Feldern können Informationen über die Eigenschaften der Probe erhalten werden. Insbesondere kann aus der Lage und Intensität von NMR-Linien auf die chemischen Bindungsverhältnisse in der Probe geschlossen werden.

Die Homogenität des starken statischen Magnetfeld B₀ in z-Richtung ist für die Qualität der Messung entscheidend. Zur Beeinflussung und Homogenisierung des Magnetfeldes eines NMR-Systems werden komplexe Spulensysteme eingesetzt, sogenannte Shimsysteme.

### Stand der Technik

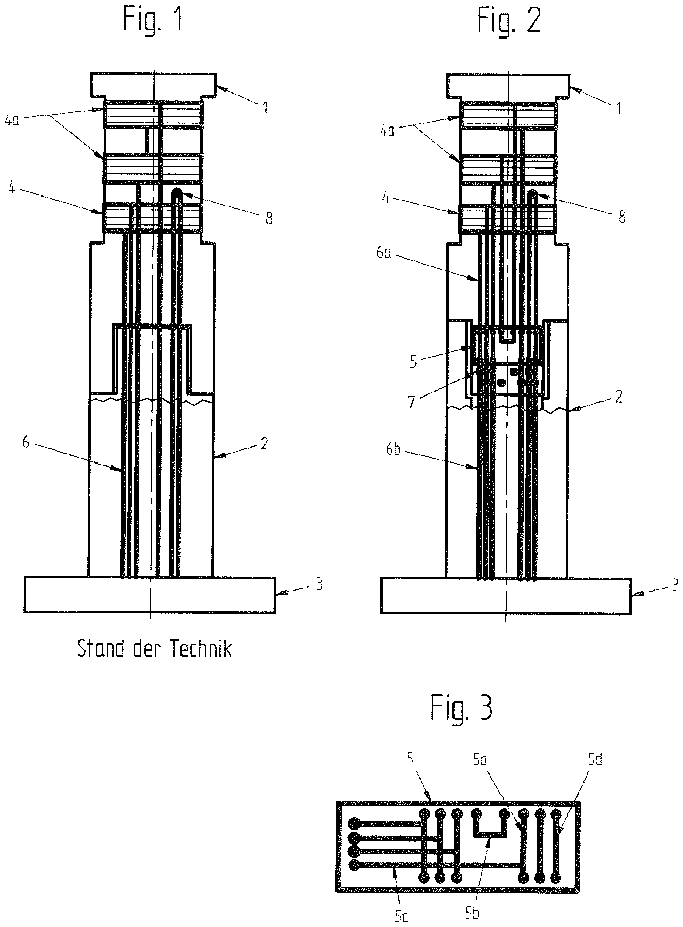

Fig. 1 zeigt vereinfacht ein Shimsystem nach dem bisherigen Stand der Technik. Dargestellt sind dabei nur die Teilspulen, welche in z-Richtung das statische Magnetfeld B₀ beeinflussen.

Die Herstellung der Teilspulen und der Verbindungen dieser Teilspulen mit der Anschlusseinheit erfolgt auf Wickelmaschinen. Dazu werden vorab der Spulenkörper, das Verlängerungsrohr und Teile der Verbindungseinheit zusammengebaut und diese vormontierte Einheit auf der Wickelmaschine eingespannt.

Das Wickeln erfolgt dann so, dass ein Draht als Verbindungsleitung an der Anschlusseinheit fixiert und von dieser entlang und in Längsnuten des Verlängerungsrohres und des Spulenkörpers bis zur ersten, von der Anschlusseinheit am weitesten entfernten Umfangsnut der ersten Teilspule geführt wird. Danach wird mit demselben Draht diese Teilspule gewickelt und der Draht wieder als Verbindungsleitung in gleicher Weise wieder zur Anschlusseinheit zurückgeführt und dort fixiert.

Anschließend werden in gleicher Weise die nächsten Teilspulen erzeugt. Die Anschlussleitungen zu den vorgängigen Teilspulen kommen so unter die nächsten Teilspulen zu liegen.

Komplizierter wird der Vorgang, wenn zwei nicht benachbarte Teilspulen in Serie geschaltet werden müssen. Dann muss zuerst die erste der beiden Teilspulen wie vorgängig beschrieben gewickelt werden. Die Anschlussleitung wird dann aber nicht bis zur Anschlusseinheit zurückgeführt, sondern die Drahtrolle, von welcher der Draht für die Anschlussleitung abgewickelt wird, muss provisorisch in der Nähe der Anschlusseinheit fixiert werden, so dass sie beim Wickeln der nächsten Teilspulen mitdreht und nicht weiter abgewickelt wird. Danach werden die Teilspulen erzeugt, welche zwischen den in Serie zu schaltenden Teilspulen liegen. Anschließend wird die Drahtrolle wiederaufgenommen und die zweite der in Serie geschalteten Spulen gewickelt und dann der Draht als Anschlussleitung zur Anschlusseinheit geführt und fixiert. Sollen zwei in Serie geschaltete Teilspulen eine unterschiedliche Polarität erhalten, müssen die beiden Teilspulen in unterschiedlicher Wicklungsrichtung aufgebracht werden.

Nachteilig ist dabei, dass diese Prozedur dermaßen kompliziert ist, dass eine Automatisation dieses Fertigungsvorganges nicht mehr mit vertretbarem Aufwand realisiert werden kann.

Ein weiterer Nachteil von Shimspulen, welche nach oben beschriebenem Stand der Technik gefertigt werden, besteht darin, dass vor dem zeitaufwändigen Wickelprozess bereits der Spulenkörper mit dem Verlängerungsrohr verbunden werden muss. Weil je nach notwendiger Länge des Shimsystems unterschiedlich lange Verlängerungsrohre vorliegen, muss demnach zu diesem Zeitpunkt bereits endgültig entschieden sein, welche Länge des Shimsystems produziert werden soll.

Es ist derzeit nicht möglich, die zeitaufwändigen Wicklungen der Teilspulen vorab auf Lager zu fertigen. Dies würde es erlauben, nach Bestellungseingang eine Shimspule viel rascher fertigen zu können, weil dann nur noch ein bereits mit seinen Teilspulen bestückter Spulenkörper mit dem richtigen Verlängerungsrohr und den übrigen Teilen montiert werden müsste. Stattdessen ist gemäß dem Stand der Technik nur eine aufwändige manuelle Fertigung in der oben beschriebenen Weise möglich.

### Aufgabe der Erfindung

Der vorliegenden Erfindung liegt demgegenüber die Aufgabe zugrunde, mit einfachen technischen Maßnahmen unter Verwendung von Standard-Bauteilen und ohne nennenswerten zusätzlichen Kostenaufwand das Shimsystem in seinem mechanischen Aufbau derart umzugestalten, dass die Herstellung der Teilwicklungen auf dem Spulenkörper ohne ein bereits montiertes Verlängerungsrohr und möglichst wirtschaftlich, in vereinfachter Weise sowie automatisiert erfolgen kann.

### Kurze Beschreibung der Erfindung

Diese Aufgabe wird auf ebenso überraschend einfache wie wirkungsvolle Weise dadurch gelöst, dass die Anschlussleitungen zwischen Spulenkörper und Verlängerungsrohr geteilt und durch eine dazwischen angeordnete Leiterplatte mit Verbindungsleitungen wieder miteinander verbunden sind.

Dadurch wird ermöglicht, dass die Teilspulen auf den Spulenkörper gewickelt werden können, ohne dass vorher bereits ein Verlängerungsrohr und Teile der Anschlusseinheit montiert werden müssen, um die Enden der Anschlussleitungen fixieren zu können. Zudem wird der Herstellprozess für alle Teilspulen vereinheitlicht. Außerdem gibt es keinen komplizierten Prozess mehr für mehrere in Serie geschaltete Teilspulen. Sollen zwei in Serie geschaltete Teilspulen eine unterschiedliche Polarität erhalten, kann dies einfach durch geeignete Anordnung der Verbindungsleitungen auf der Leiterplatte geschehen.

### Bevorzugte Ausführungsformen der Erfindung

Bei einer bevorzugten Ausführungsform der erfindungsgemäßen Shimspule sind die geteilten Anschlussleitungen zwischen Spulenkörper und Verlängerungsrohr durch die dazwischen angeordnete Leiterplatte mit Lötpunkten und Verbindungsleitungen lötbar wieder miteinander verbunden. Dazu kann die Leiterplatte zusätzliche, ergänzende und weitere Verbindungsleitungen sowie Lötpunkte zur Verbindung der Anschlussleitungen von den Teilspulen zur seriellen Verbindung von zwei oder mehreren Teilspulen tragen.

Weitere vorteilhafte Ausführungsformen sind dadurch gekennzeichnet, dass die geteilten Anschlussleitungen zwischen Spulenkörper und Verlängerungsrohr durch die dazwischen angeordnete Leiterplatte mittels Klemm-, Schraub- oder Steckverbindungen wieder elektrisch miteinander verbunden sind. Damit kann unterschiedlichen Verbindungstechniken Rechnung getragen werden, insbesondere auch, wenn diese automatisiert erfolgen sollen.

Besonders bevorzugt sind Ausführungsformen, bei denen die Leiterplatte nicht nur die Verbindungsleitung der Anschlussleitungen zu den Teilspulen und den Anschlussleitungen zur Anschlusseinheit enthält, sondern auch zusätzliche Verbindungsleitungen zur seriellen Verbindung einzelner Teilspulen. Dadurch erfolgt die Fertigung mehrerer seriell verbundener Teilspulen genau gleich wie die Fertigung einer einzelnen Spule, was insbesondere bei automatisierter Fertigung vereinfachend ist.

Auch kann bei einer Klasse von Ausführungsformen der erfindungsgemäßen Shimspule die Leiterplatte als flexible Leiterplatte ausgebildet und am Umfang um das untere Ende des Spulenkörpers angeordnet sein. Dies ermöglicht eine optimale Ausnutzung des verfügbaren Platzes. Es steht genügend Abstand für alle Lötpunkte zur Verfügung, ohne dass in axialer Richtung viel Platz benötigt wird.

Besonders bevorzugt ist eine Ausführungsform der Erfindung, bei der auf der flexiblen Leiterplatte zusätzlich zu den Lötpunkten und Verbindungsleitungen für die Teilspulen auch Lötpunkte und Verbindungsleitungen für weitere Zwecke wie zum Beispiel Temperatursensoren angeordnet sind. Dies ermöglicht eine weitergehende Vormontage des Spulenkörpers nicht nur mit den Teilspulen, sondern auch mit weiteren Elementen.

Eine weitere vorteilhafte Ausführungsform der Erfindung erhält man, wenn die Leiterplatte nebst Lötpads für die Anschlussleitungen auch Kontaktstellen mit den entsprechenden Verbindungsleitungen für das Testen der fertig gewickelten Teilspulen enthält. Dadurch wird es möglich, eine Testvorrichtung zu bauen, in welcher ein mit allen Teilspulen und weiteren Elementen bestückter Spulenkörper einfach getestet werden kann.

Besonders bevorzugt ist eine Anordnung der -vorzugsweise flexiblen-Leiterplatte derart, dass nach Montage des Verlängerungsrohrs die Lötverbindungen der Anschlussleitungen zu den Teilspulen und Sensoren auf der Leiterplatte geschützt angeordnet sind. Dies wird konstruktiv erreicht, indem (wie in Fig. 2 gezeigt) das Verlängerungsrohr über den Bereich des Spulenkörpers ragt, auf welchem die flexible Leiterplatte befestigt ist. Dadurch wird einer Beschädigung vorgebeugt, insbesondere beim Transport der Shimspule zum Magneten und bei Einbau in den selbigen.

Eine weitere Leistungsverbesserung gegenüber dem Stand der Technik lässt sich auch dadurch realisieren, dass die Anschlussleitungen von der Leiterplatte zur Anschlusseinheit in einem größeren Durchmesser gefertigt werden als die Anschlussleitungen von den Teilspulen zur Leiterplatte. Da die Anschlussleitungen von den Teilspulen zur Leiterplatte aus einem Stück mit den Teilspulen selber gefertigt werden, ist deren Leitungsdurchmesser durch die Platzverhältnisse der Teilspulen beschränkt. Die Aufteilung der Anschlussleitung gestattet es nun, in den beiden Teilstücken unterschiedliche Drahtdurchmesser zu verwenden. Dies reduziert den gesamten elektrischen Widerstand der einzelnen Teilspulen mitsamt ihren Anschlussleitungen, so dass bei gegebener Versorgungsspannung größere Ströme fließen können und dadurch die Leistung der Teilspulen erhöht werden kann.

Für eine automatisierte Fertigung der Teilspulen ist es nutzbringend, wenn im Anschluss an die Nuten für die Teilspulen und an den Platz für die Leiterplatte Drahtfesthaltevorrichtungen angeordnet sind. Dadurch kann der Draht für die Teilspulen und Anschlussleitungen von den Teilspulen zur Leiterplatte in einem Arbeitsgang ohne Unterbruch aufgebracht und gewickelt werden. Dabei wird der Draht zuerst an der ersten Drahtfesthaltevorrichtung fixiert, zur ersten Teilspulenposition geführt, die erste Teilspule gewickelt und dann zurück zur zweiten Drahtfesthaltevorrichtungen geführt und fixiert. Sodann wird der Draht zu der dritten Drahtfesthaltevorrichtung geführt und fixiert, zur zweiten Teilspulenposition geführt, die zweite Teilspule gewickelt und dann zurück zur vierten Drahtfesthaltevorrichtungen geführt und fixiert. Mit den übrigen Teilspulen wird gleich verfahren. Dabei wird der Draht immer über die Leiterplatte und genau über den jeweiligen Lötpunkt geführt. Sodann kann dieser Draht an allen Lötpunkten angelötet werden und schlussendlich die Drahtstücke von den Lötpunkten zu den Drahtfesthaltevorrichtungen wieder entfernt werden. Dadurch kann die Herstellung der Teilwicklungen auf dem Spulenkörper möglichst wirtschaftlich automatisiert erfolgen.

In den Rahmen der vorliegenden Erfindung fällt auch ein Verfahren zur Herstellung eines erfindungsgemäßen Shimsystems mit einem Spulenkörper (der oben beschriebenen Art, umfassend folgende Schritte:
a) Bereitstellen des Spulenkörpers mit einer darauf befindlichen Leiterplatte;
b) Verbinden einer Anschlussleitung mit einer der Drahtfesthaltevorrichtungen des Spulenkörpers;
c) Verlegen der Anschlussleitung zu einem oberen Ende eines Teilspulenbereiches für Teilspulen mit ungerader Anzahl von Lagen oder zu einem unteren Ende eines Teilspulenbereiches für Teilspulen mit gerader Anzahl von Lagen;
d) Wickeln einer Teilspule mit einer oder mehreren Lagen zu einem der Leiterplatte zugewandten unteren Ende des Teilspulenbereiches hin;
e) Verlegen der Anschlussleitung zu einer der Drahtfesthaltevorrichtungen;
f) Verlegen der Anschlussleitung zu einer nächsten Drahtfesthaltevorrichtungen (7) für die nächste Teilspule;
g) Wiederholen der Schritte c) bis f) für jede Teilspule;
h) Verbinden aller Anschlussleitungen mit der Leiterplatte;
i) Entfernen der Anschlussleitungsteile zwischen der Leiterplatte und den Drahtfesthaltevorrichtungen;
j) Montieren des Verlängerungsrohres, der Anschlusseinheit und Verbinden aller Anschlussleitungen mit der Leiterplatte mit der Anschlusseinheit.

Vorteilhaft an diesem Verfahren ist, dass alle Teilspulen mit einem einzigen Draht in einem zusammenhängenden Prozess gewickelt werden können, was besonders effizient ist.

Besonders vorteilhaft ist eine Variante dieses Verfahrens, bei welcher die Fertigungsschritte b) bis g) vollständig automatisiert abgearbeitet werden. Dadurch kann in kürzerer Zeit und zu geringeren Kosten eine Shimspule in besserer Qualität hergestellt werden als nach dem Stand der Technik.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: ein Shimsystem nach dem Stand der Technik in schematischer Seitenansicht;
- Fig. 2: ein erfindungsgemäßes Shimsystem; und
- Fig. 3: eine schematische Draufsicht auf eine Leiterplatte des erfindungsgemäßen Shimsystems.

Figur 1 zeigt systematisch ein Shimsystem bisheriger Bauart gemäß dem Stand der Technik. Es ist aufgebaut aus einem **Spulenkörper 1,** einem **Verlängerungsrohr 2** und einer **Anschlusseinheit 3.** Die einzelnen auf den Spulenkörper 1 aufgebrachten **Teilspulen 4** und die **Anschlussleitungen 6** bestehen jeweils aus einem durchgängigen Draht. Dies gilt auch für **in Serie geschaltete Teilspulen 4a.** Die Anschlussleitungen zu einem **Sensor 8** bestehen aus zwei durchgängigen Drähten. Die Anschlussleitungen führen durchgängig bis zur Anschlusseinheit 3. Die in Serie geschalteten Teilspulen 4a sind direkt seriell gewickelt.

Figur 2 stellt systematisch eine mögliche Ausführungsform des Shimsystems gemäß der vorliegenden Erfindung dar. Dieses ist ebenfalls aufgebaut aus einem Spulenkörper 1, einem Verlängerungsrohr 2 und einer Anschlusseinheit 3. Zusätzlich ist erfindungsgemäß eine **Leiterplatte 5** vorgesehen. Außerdem sind die Anschlussleitungen bei der Erfindung im Gegensatz zu den durchgängigen Anschlussleitungen 6 gemäß dem Stand der Technik aufgeteilt in **Anschlussleitungen 6a** von den Teilspulen 4, 4a zur Leiterplatte 5 sowie **Anschlussleitungen 6b** von der Leiterplatte 5 zur Anschlusseinheit 3. Die auf den Spulenkörper 1 aufgebrachten Teilspulen 4 und die Anschlussleitungen 6a bestehen aus einem durchgängigen Draht. Bei den in Serie geschalteten Teilspulen 4a sind die Anschlussleitungen 6a, 6b in gleicher Weise angeordnet. Die serielle Verbindung erfolgt erst auf der Leiterplatte 5. Im Anschluss an die Nuten für die Teilspulen 4 und den Platz für die Leiterplatte 5 sind **Drahtfesthaltevorrichtungen 7** angeordnet.

Figur 3 zeigt schematisch eine Leiterplatte 5 des erfindungsgemäßen Shimsystems. Darauf erkennt man die **Verbindungsleitungen 5a** mit Lötpunkten für die Anschlussleitungen 6a und 6b, die **zusätzlichen Verbindungsleitungen 5b** mit Lötpunkten für die Anschlussleitungen 6a zweier seriell geschalteter Teilspulen 4a, die **weiteren Verbindungsleitungen 5c** mit Kontaktestellen für die Verbindung von Teilspulen 4, 4a mit einem Testgerät sowie die **ergänzenden Verbindungsleitungen 5d** für die Anschlussleitungen 6a und 6b zu beispielsweise einem Temperatursensor 8.

### Bezugszeichenliste

- (1): Spulenkörper
- (2): Verlängerungsrohr
- (3): Anschlusseinheit
- (4): Teilspulen
- (4a): zwei oder mehrere in Serie geschaltete Teilspulen
- (5): MAS-Rotor mit eingebrachter zu untersuchender Substanz
- (5): Leiterplatte
- (5a): Verbindungsleitung auf der Leiterplatte mit Lötpunkten für die Anschlussleitungen (6a) und (6b) von Teilspulen zur Anschlusseinheit
- (5b): zusätzliche Verbindungsleitungen auf der Leiterplatte mit Lötpunkten für die serielle Verbindung von Anschlussleitungen (6a) zweier Teilspulen
- (5c): weitere Verbindungsleitungen auf der Leiterplatte mit Kontaktstellen für die Verbindung von Teilspulen mit einem Testgerät
- (5d): ergänzende Verbindungsleitungen auf der Leiterplatte mit Lötpunkten für die Anschlussleitungen (6a) und (6b) von zum Beispiel Temperatursensoren (8)
- (6): Anschlussleitungen von den Teilspulen zur Anschlusseinheit
- (6a): Anschlussleitungen von den Teilspulen zur Leiterplatte
- (6b): Anschlussleitungen von der Leiterplatte zur Anschlusseinheit
- (7): Drahtfesthaltevorrichtungen
- (8): Sensor, zum Beispiel Temperatursensor

### Referenzliste

Für die Beurteilung der Patentfähigkeit in Betracht gezogene Publikationen:
[1] CN 104865544 A
[2] US 3735306 A, DE 21 52 006 C2

## Patentansprüche

1. Shimsystem zur Beeinflussung und Homogenisierung des Magnetfeldes eines NMR-Systems mit einem Spulenkörper (1), einer Anschlusseinheit (3) und einem zwischen Spulenkörper (1) und Anschlusseinheit (3) angeordneten Verlängerungsrohr (2) sowie mit auf dem Spulenkörper (1) aufgebrachten Teilspulen (4, 4a) mit Anschlussleitungen (6; 6a,6b) zur Verbindung der Teilspulen (4, 4a) mit der Anschlusseinheit (3),
**dadurch gekennzeichnet,**
**dass** die Anschlussleitungen (6a,6b) zwischen Spulenkörper (1) und Verlängerungsrohr (2) geteilt und durch eine dazwischen angeordnete Leiterplatte (5) mit Verbindungsleitungen (5a, 5b, 5c, 5d) wieder miteinander verbunden sind.

2. Shimsystem nach Anspruch 1, **dadurch gekennzeichnet, dass** die geteilten Anschlussleitungen (6a,6b) zwischen Spulenkörper (1) und Verlängerungsrohr (2) durch die dazwischen angeordnete Leiterplatte (5) mit Lötpunkten und Verbindungsleitungen (5a, 5b, 5c, 5d) lötbar wieder miteinander verbunden sind.

3. Shimsystem nach Anspruch 1 oder 2, **dadurch gekennzeichnet, dass** die geteilten Anschlussleitungen (6a,6b) zwischen Spulenkörper (1) und Verlängerungsrohr (2) durch die dazwischen angeordnete Leiterplatte (5) mittels Klemm-, Schraub- oder Steckverbindungen wieder elektrisch miteinander verbunden sind.

4. Shimsystem nach einem der vorhergehenden Ansprüche, **dadurch gekennzeichnet, dass** die Leiterplatte (5) nicht nur die Verbindungsleitung (5a) der Anschlussleitungen (6a) zu den Teilspulen (4) und den Anschlussleitungen (6b) zur Anschlusseinheit (3) enthält, sondern auch zusätzliche Verbindungsleitungen (5b) zur seriellen Verbindung einzelner Teilspulen (4).

5. Shimsystem nach einem der vorhergehenden Ansprüche, **dadurch gekennzeichnet, dass** die Leiterplatte (5) als flexible Leiterplatte ausgebildet und am Umfang um das untere Ende des Spulenkörpers (1) befestigt ist.

6. Shimsystem nach Anspruch 5, **dadurch gekennzeichnet, dass** die flexible Leiterplatte so auf dem Spulenkörper (1) angeordnet ist, dass nach Montage des Verlängerungsrohrs (2) Lötverbindungen der Anschlussleitungen (6a) zu den Teilspulen (4) und Sensoren (8) auf der Leiterplatte (5) geschützt angeordnet sind.

7. Shimsystem nach einem der vorhergehenden Ansprüche, **dadurch gekennzeichnet, dass** auf der Leiterplatte (5) zusätzlich zu Lötpunkten und Verbindungsleitungen (5a) für die Teilspulen (4) auch Lötpunkte und ergänzende Verbindungsleitungen (5d) für weitere Zwecke wie zum Beispiel Temperatursensoren (8) angeordnet sind.

8. Shimsystem nach einem der vorhergehenden Ansprüche, **dadurch gekennzeichnet, dass** die Leiterplatte (5) nebst Lötpads für die Anschlussleitungen (6) auch Kontaktstellen mit den entsprechenden weiteren Verbindungsleitungen (5c) für das Testen der fertig gewickelten Teilspulen (4) enthält.

9. Shimsystem einem der vorhergehenden Ansprüche, **dadurch gekennzeichnet, dass** die Anschlussleitungen (6b) von der Leiterplatte (5) zur Anschlusseinheit (3) einen anderen, bevorzugt einen größeren Drahtdurchmesser haben als die Anschlussleitungen (6a) von den Teilspulen (4) zur Leiterplatte (5).

10. Verfahren zur Herstellung eines Shimsystems nach einem der Ansprüche 1 bis 9 mit einem Spulenkörper (1), bei dem Drahtfesthaltevorrichtungen (7) im Anschluss an Nuten für die Teilspulen (4) und die Leiterplatte (5) angeordnet sind, umfassend folgende Schritte:
a) Bereitstellen des Spulenkörpers (1) mit einer darauf befindlichen Leiterplatte (5);
b) Verbinden einer Anschlussleitung (6a) mit einer der Drahtfesthaltevorrichtungen (7) des Spulenkörpers (1);
c) Verlegen der Anschlussleitung (6a) zu einem oberen Ende eines Teilspulenbereiches für Teilspulen (4) mit ungerader Anzahl von Lagen oder zu einem unteren Ende eines Teilspulenbereiches für Teilspulen (4) mit gerader Anzahl von Lagen;
d) Wickeln einer Teilspule (4) mit einer oder mehreren Lagen zu einem der Leiterplatte (5) zugewandten unteren Ende des Teilspulenbereiches hin;
e) Verlegen der Anschlussleitung (6a) zu einer der Drahtfesthaltevorrichtungen (7);
f) Verlegen der Anschlussleitung (6a) zu einer nächsten Drahtfesthaltevorrichtungen (7) für die nächste Teilspule (4);
g) Wiederholen der Schritte c) bis f) für jede Teilspule (4);
h) Verbinden aller Anschlussleitungen (6a) mit der Leiterplatte (5);
i) Entfernen der Anschlussleitungsteile zwischen der Leiterplatte (5) und den Drahtfesthaltevorrichtungen (7);
j) Montieren des Verlängerungsrohres (2), der Anschlusseinheit (3) und Verbinden aller Anschlussleitungen (6b) mit der Leiterplatte (5) mit der Anschlusseinheit (3).

11. Verfahren nach Anspruch 10, **dadurch gekennzeichnet, dass** die Fertigungsschritte b) bis g) vollständig automatisiert abgearbeitet werden.

## Claims

1. Shim system for influencing and homogenizing the magnetic field of an NMR system, comprising a coil former (1), a terminal unit (3) and an extension tube (2) arranged between the coil former (1) and the terminal unit (3), as well as comprising partial coils (4, 4a) that are mounted on the coil former (1) and have terminal lines (6; 6a, 6b) for connecting the partial coils (4, 4a) to the terminal unit (3),
**characterized in that**
the terminal lines (6a, 6b) are split between the coil former (1) and the extension tube (2) and are reconnected to one another by an interposed circuit board (5) with connection lines (5a, 5b, 5c, 5d).

2. Shim system according to claim 1, **characterized in that** the split terminal lines (6a, 6b) between the coil former (1) and the extension tube (2) are solderably reconnected to one another by the interposed circuit board (5) with solder points and connection lines (5a, 5b, 5c, 5d).

3. Shim system according to claim 1 or 2, **characterized in that** the split terminal lines (6a, 6b) between the coil former (1) and the extension tube (2) are electrically reconnected to one another by the interposed circuit board (5) by means of clamp, screw or plug connections.

4. Shim system according to any of the preceding claims, **characterized in that** the circuit board (5) contains not only the connection line (5a) of the terminal lines (6a) to the partial coils (4) and the terminal lines (6b) to the terminal unit (3), but also additional connection lines (5b) for the serial connection of individual partial coils (4).

5. Shim system according to any of the preceding claims, **characterized in that** the circuit board (5) is designed as a flexible circuit board and is fastened at the periphery around the lower end of the coil former (1).

6. Shim system according to claim 5, **characterized in that** the flexible circuit board is arranged on the coil former (1) such that, after fitting the extension tube (2), solder connections of the terminal lines (6a) to the partial coils (4) and sensors (8) are arranged on the circuit board (5) in a protected manner.

7. Shim system according to any of the preceding claims, **characterized in that**, in addition to the solder points and connection lines (5a) for the partial coils (4), solder points and supplementary connection lines (5d) for other purposes, such as temperature sensors (8), are also arranged on the circuit board (5).

8. Shim system according to any of the preceding claims, **characterized in that** the circuit board (5), in addition to solder pads for the terminal lines (6), also contains contact points with the corresponding further connection lines (5c) for testing the fully wound partial coils (4).

9. Shim system according to any of the preceding claims, **characterized in that** the terminal lines (6b) from the circuit board (5) to the terminal unit (3) have a different, preferably larger wire diameter than the terminal lines (6a) from the partial coils (4) to the circuit board (5).

10. Method for producing a shim system according to any of claims 1 to 9 comprising a coil former (1), in which wire-holding devices (7) are arranged after the grooves for the partial coils (4) and the circuit board (5), comprising the following steps:
a) providing the coil former (1) having a circuit board (5) thereon ;
b) connecting a terminal line (6a) to one of the wire-holding devices (7) of the coil former (1);
c) moving the terminal line (6a) to an upper end of a partial coil region for partial coils (4) having an uneven number of layers or to a lower end of a partial coil region for partial coils (4) having an even number of layers;
d) winding a partial coil (4) having one or more layers towards a lower end of the partial coil region that faces the circuit board (5);
e) moving the terminal line (6a) to one of the wire-holding devices (7);
f) moving the terminal line (6a) to one of the subsequent wire-holding devices (7) for the subsequent partial coil (4);
g) repeating steps c) to f) for every partial coil (4);
h) connecting all the terminal lines (6a) to the circuit board (5);
i) removing the terminal line parts between the circuit board (5) and the wire-holding devices (7);
j) fitting the extension tube (2) and the terminal unit (3) and connecting all the terminal lines (6b) to the circuit board (5) to the terminal unit (3).

11. Method according to claim 10, **characterized in that** the production steps b) to g) are carried out in a completely automated manner.

## Revendications

1. Système de correction ou de shim pour influencer et homogénéiser le champ magnétique d'un système de résonance magnétique nucléaire, RMN, comprenant un corps de bobine (1), une unité de raccordement (3) et un tube prolongateur (2) disposé entre le corps de bobine (1) et l'unité de raccordement (3) ainsi que comprenant des bobines partielles (4, 4a) montées sur le corps de bobine (1) avec des lignes de raccordement (6 ; 6a, 6b) pour relier les bobines partielles (4, 4a) à l'unité de raccordement (3),
**caractérisé en ce**
**que** les lignes de raccordement (6a, 6b) sont divisées entre le corps de bobine (1) et le tube prolongateur (2) et de nouveau reliées les unes aux autres par une carte de circuit imprimé (5) disposée entre elles et comportant des lignes de connexion (5a, 5b, 5c, 5d).

2. Système de correction selon la revendication 1, **caractérisé en ce que** les lignes de raccordement (6a, 6b) divisées entre le corps de bobine (1) et le tube prolongateur (2) sont de nouveau reliées les unes aux autres de manière brasable par la carte de circuit imprimé (5) disposée entre elles et comportant des points de brasage et des lignes de connexion (5a, 5b, 5c, 5d).

3. Système de correction selon la revendication 1 ou 2, **caractérisé en ce que** les lignes de raccordement (6a, 6b) divisées entre le corps de bobine (1) et le tube prolongateur (2) sont de nouveau reliées électriquement les unes aux autres par la carte de circuit imprimé (5) disposée entre elles au moyen de liaisons par serrage, vissage ou enfichage.

4. Système de correction selon l'une des revendications précédentes, **caractérisé en ce que** la carte de circuit imprimé (5) contient non seulement la ligne de connexion (5a) des lignes de raccordement (6a) allant aux bobines partielles (4) et les lignes de raccordement (6b) allant à l'unité de raccordement (3), mais aussi des lignes de connexion supplémentaires (5b) pour la connexion en série de bobines partielles individuelles (4).

5. Système de correction selon l'une des revendications précédentes, **caractérisé en ce que** la carte de circuit imprimé (5) est réalisée sous la forme d'une carte de circuit imprimé flexible et est fixée à la périphérie autour de l'extrémité inférieure du corps de bobine (1).

6. Système de correction selon la revendication 5, **caractérisé en ce que** la carte de circuit imprimé flexible est disposée sur le corps de bobine (1) de telle sorte qu'après le montage du tube prolongateur (2), des brasures des lignes de raccordement (6a) allant aux bobines partielles (4) et à des capteurs (8) sont disposées de manière protégée sur la carte de circuit imprimé (5).

7. Système de correction selon l'une des revendications précédentes, **caractérisé en ce que**, en plus des points de brasage et des lignes de connexion (5a) pour les bobines partielles (4), des points de brasage et des lignes de connexion supplémentaires (5d) pour d'autres usages, comme par exemple des capteurs de température (8), sont également disposés sur la carte de circuit imprimé (5).

8. Système de correction selon l'une des revendications précédentes, **caractérisé en ce que** la carte de circuit imprimé (5) contient, en plus des pastilles de brasage pour les lignes de raccordement (6), également des points de contact avec les autres lignes de connexion correspondantes (5c) pour le test des bobines partielles (4) bobinées.

9. Système de correction selon l'une des revendications précédentes, **caractérisé en ce que** les lignes de raccordement (6b) allant de la carte de circuit imprimé (5) à l'unité de raccordement (3) ont un diamètre de fil différent, de préférence plus grand, que les lignes de raccordement (6a) allant des bobines partielles (4) à la carte de circuit imprimé (5).

10. Procédé de fabrication d'un système de correction selon l'une des revendications 1 à 9 comprenant un corps de bobine (1), dans lequel des dispositifs de maintien de fil (7) sont disposés à la suite de rainures pour les bobines partielles (4) et la carte de circuit imprimé (5), comprenant les étapes suivantes consistant à :
a) mettre à disposition le corps de bobine (1) avec une carte de circuit imprimé (5) se trouvant sur celui-ci ;
b) relier une ligne de raccordement (6a) à l'un des dispositifs de maintien de fil (7) du corps de bobine (1) ;
c) poser la ligne de raccordement (6a) vers une extrémité supérieure d'une zone de bobine partielle pour les bobines partielles (4) ayant un nombre impair de couches ou vers une extrémité inférieure d'une zone de bobine partielle pour les bobines partielles (4) ayant un nombre pair de couches ;
d) bobiner une bobine partielle (4) avec une ou plusieurs couches vers une extrémité inférieure de la zone de bobine partielle tournée vers la carte de circuit imprimé (5) ;
e) poser la ligne de raccordement (6a) vers l'un des dispositifs de maintien de fil (7) ;
f) poser la ligne de raccordement (6a) vers un dispositif de maintien de fil suivant (7) pour la bobine partielle suivante (4) ;
g) répéter les étapes c) à f) pour chaque bobine partielle (4) ;
h) relier toutes les lignes de raccordement (6a) à la carte de circuit imprimé (5) ;
i) retirer les parties de ligne de raccordement entre la carte de circuit imprimé (5) et les dispositifs de maintien de fil (7) ;
j) monter le tube prolongateur (2), l'unité de raccordement (3) et relier toutes les lignes de raccordement (6b) à la carte de circuit imprimé (5) et à l'unité de raccordement (3).

11. Procédé selon la revendication 10, **caractérisé en ce que** les étapes de fabrication b) à g) sont mises en œuvre de façon entièrement automatisée.
